# EUROPÄISCHE PATENTSCHRIFT

(11) **EP 0 630 176 B1**
(45) Veröffentlichungstag und Bekanntmachung des Hinweises auf die Patenterteilung: **20.01.1999**
(21) Anmeldenummer: 94105838.0
(22) Anmeldetag: 15.04.1994
(51) Int. Cl.: H05K 7/20, H01L 23/498, H01L 23/367

(54) **Elektrische Baugruppe**
Electrical assembly
Eléments constructifs électriques

(30) Priorität: 14.06.1993 DE 9308842 U
(43) Veröffentlichungstag der Anmeldung: 21.12.1994
(73) Patentinhaber: Blaupunkt-Werke GmbH, D-31139 Hildesheim (DE)
(72) Erfinder: Dobers, Michael, Dr., D-31134 Hildesheim (DE); Seyffert, Martin, Dr., D-31139 Hildesheim (DE)

(56) Entgegenhaltungen:
- DE-A- 3 115 017
- DE-A- 4 107 312
- IBM TECHNICAL DISCLOSURE BULLETIN., Bd.33, Nr.4, September 1990, NEW YORK US Seiten 403 - 404, XP000106478 'Thermal enhancement for a printed wiring board, thermal finger pad'
- RESEARCH DISCLOSURE, Nr.332, Dezember 1991, HAVANT GB Seite 975, XP000274693 'Use of metal-column thermal interface for cooling semiconductor devices'
- PATENT ABSTRACTS OF JAPAN vol. 5, no. 171 (E-80) (843) 30. Oktober 1981 & JP-A-56 100 458 (NIPPON DENKI K.K.) 12. August 1981

## Beschreibung

Die Erfindung geht aus von einer elektrischen Baugruppe mit mindestens einem wärmeerzeugenden Bauelement, das auf einer Seite einer Leiterplatte angeordnet ist.

Eine Baugruppe gemäß dem Oberbegriff des Anspruchs 1 ist aus DE-A-4 107 312 bekannt.

Die zur Herstellung von Leiterplatten verwendeten Isolierstoffe haben eine geringe Wärmeleitfähigkeit, so daß die Abführung der durch die elektrische Verlustleistung in Bauelementen entstehende Wärme in elektrischen Schaltungen häufig Schwierigkeiten bereitet. Dieses gilt um so mehr, je höher der Grad der Miniaturisierung ist, was insbesondere bei einigen Modul-Bauformen gegeben ist. So sind beispielsweise Module bekannt, deren Kontaktierung mit der Leiterplatte über eine flächige Anordnung von Lotkugeln erfolgt, die als "Ball Grid Array" oder auch "Solder Grid Array" bekannt sind.

Aufgabe der vorliegenden Erfindung ist es, eine elektrische Baugruppe (Modul) anzugeben, bei welcher eine gute Wärmeableitung zu einer Haupt-Leiterplatte möglich ist.

Diese Aufgabe wird erfindungsgemäß dadurch gelöst, daß die Kupferschicht auf der anderen Seite der Leiterplatte zur thermisch leitenden Verbindung mit einer Haupt-Leiterplatte durch Lötung von Lotkugeln entstandene Lötstellen aufweist.

Die erfindungsgemäße Baugruppe hat den Vorteil, daß gegenüber einem herkömmlichen Modul mit thermisch isolierender Leiterplatte ein wesentlich geringerer Wärmewiderstand zwischen dem wärmeerzeugenden Bauelement und der Haupt-Leiterplatte vorliegt. Außerdem hat die erfindungsgemäße Baugruppe den Vorteil, daß die erfindungsgemäßen Maßnahmen mit den gleichen Verfahren verwirklicht werden wie die ohnehin erforderliche Herstellung von Leiterbahnen und Durchkontaktierungen.

Im Zusammenhang mit der vorliegenden Erfindung werden die Lotkugeln als Kugeln bezeichnet, auch wenn ihre Form beim fertigen Erzeugnis von der Kugelform abweicht.

Eine vorteilhafte Ausgestaltung der Erfindung besteht darin, daß die Kupferschichten die der Leiterplatte zugewandte Fläche des Bauelements im wesentlichen überdecken und daß die Durchkontaktierungen und die Mittel zur thermisch leitenden Verbindung mit der Haupt-Leiterplatte auf der überdeckten Fläche rasterförmig verteilt sind. Vorzugsweise ist dabei vorgesehen, daß Leiterbahnen, weitere Lotkugeln und weitere Durchkontaktierungen an den Rändern der überdeckten Fläche zur Verbindung des Bauelements mit der Haupt-Leiterplatte vorgesehen sind. Dabei ergibt sich eine bessere Wärmeableitung je enger und je zahlreicher die Durchkontaktierungen angeordnet sind.

Es ist jedoch im Rahmen der Erfindung auch möglich, elektrische Verbindungen innerhalb der vom Bauelement überdeckten Fläche vorzusehen - beispielsweise, um Modulfläche einzusparen.

Eine weitere Verbesserung der Wärmeableitung kann gemäß einer Weiterbildung der Erfindung dadurch erfolgen, daß das Bauelement mit einer thermisch leitenden Kappe versehen ist, welche thermisch leitend mit der Kupferschicht auf der einen Seite der Leiterplatte verbunden ist.

Ausführungsbeispiele der Erfindung sind in der Zeichnung anhand mehrerer Figuren dargestellt und in der nachfolgenden Beschreibung näher erläutert. Es zeigt:
- Fig. 1: einen Querschnitt durch ein Ausführungsbeispiel,
- Fig. 2: eine Ansicht eines weiteren Ausführungsbeispiels von der der Haupt-Leiterplatte zugewandten Seite und
- Fig. 3: eine Kappe zur Verbesserung der Wärmeableitung.

Gleiche Teile sind in den Figuren mit gleichen Bezugszeichen versehen.

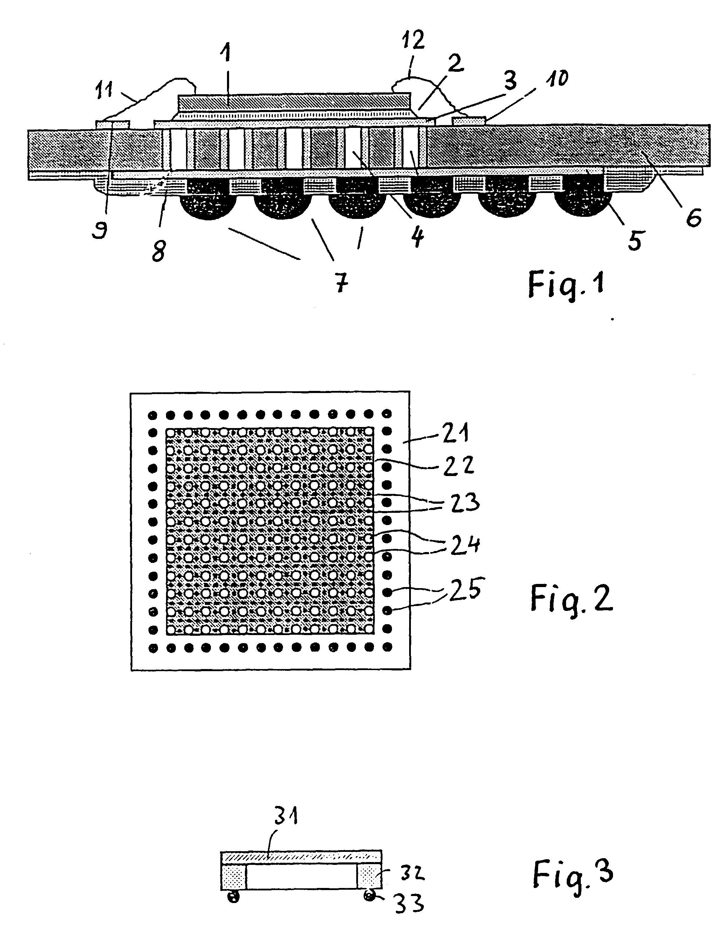

Bei dem in Fig. 1 dargestellten Ausführungsbeispiel ist ein wärmeerzeugender integrierter Schaltkreis 1 mit Hilfe eines thermischen Leitklebers 2 auf eine obere Kupferschicht 3 aufgeklebt, die mit Hilfe von Durchkontaktierungen 4 in thermischer Verbindung mit einer unteren Kupferschicht 5 steht. Dadurch erfolgt eine wesentlich bessere Wärmeableitung als durch das Trägermaterial der Leiterplatte 6 allein. Darüberhinaus trägt die Kupferschicht 3 zu einer gleichmäßigen Verteilung der Wärme über die gesamte Fläche des integrierten Schaltkreises 1 bei, so daß die einzelnen Durchkontaktierungen 4 in gleichem Maße zur Wärmeabfuhr beitragen. Außerdem wird dadurch eine Konzentration der Wärme an einer Stelle des integrierten Schaltkreises vermieden.

Zur Weiterleitung der Wärme an eine in Fig. 1 nicht dargestellte Haupt-Leiterplatte dienen Lotkugeln 7. Damit bei der Herstellung des erfindungsgemäßen Moduls das Lot gezielt aufgebracht wird und eine kugelförmige Struktur des Lotes entsteht, ohne nicht gewünschte Stellen der Kupferschicht 5 zu benetzen, ist vor dem Lötvorgang ein Lötstopplack 8 aufgebracht worden. Die Leiterplatte 6 trägt ferner Leiterbahnen 9, 10, an welche über Bond-Drähte 11, 12 Kontakte des integrierten Schaltkreises angeschlossen sind.

Bei dem in Fig. 2 dargestellten Ausführungsbeispiel ist der größte Teil einer Leiterplatte 21 mit zwei gegenüberliegenden Kupferschichten versehen, von denen in Fig. 2 nur die untere Kupferschicht 22 sichtbar ist. Rasterförmig über die Fläche der Kupferschicht 22 verteilt sind Durchkontaktierungen 23, die in Fig. 2 als kleine schwarze Punkte dargestellt sind. Ebenfalls rasterförmig verteilt sind Lotkugeln 24, welche an sich nur die Aufgabe haben, Wärme einer Kupferschicht 22 auf die Haupt-Leiterplatte abzuleiten, jedoch auch zur mechanischen Fixierung der Leiterplatte auf der Haupt-Leiterplatte beitragen. Zur elektrischen Verbindung der in Fig. 2 nicht sichtbaren Bauelemente bzw. den entsprechenden Leiterbahnen auf der Leiterplatte 21 mit Leiterbahnen der Haupt-Leiterplatte sind weitere Lotkugeln 25 vorgesehen.

Fig. 3 zeigt einen Querschnitt durch eine Kappe, welche gleichzeitig als Schutz eines Bauelements und zur Wärmeableitung dient. Bei dem in Fig. 3 dargestellten Ausführungsbeispiel besteht die Kappe aus einer Aluminium-Scheibe 31 und einem galvanisch-verkupferten Ring 32 aus einem Kunststoff, beispielsweise aus glasfaserverstärktem Epoxid. An der Unterseite des Ringes befinden sich Lotkugeln 33, die zur Befestigung und zur Wärmeableitung vom Ring 32 bzw. der Kappe dienen.

## Patentansprüche

1. Elektrische Baugruppe mit mindestens einem wärmeerzeugenden Bauelement, das auf einer Seite einer Leiterplatte angeordnet ist, wobei zusätzlich zu Leiterbahnen (10) und gegebenenfalls vorhandenen Durchkontaktierungen, welche elektrische Verbindungen zwischen den Seiten der Leiterplatte (6) darstellen, auf beiden Seiten der Leiterplatte (6) Kupferschichten (3,5,22) vorgesehen sind, die mit Durchkontaktierungen (4, 23) untereinander verbunden sind und wobei die Kupferschicht (3) auf der einen Seite der Leiterplatte in thermisch leitender Verbindung mit dem Bauelement (1) steht, dadurch gekennzeichnet, daß die Kupferschicht (5, 22) auf der anderen Seite der Leiterplatte zur thermisch leitenden Verbindung mit einer Haupt-Leiterplatte durch Lötung von Lotkugeln (7, 24) entstandene Lötstellen aufweist.

2. Baugruppe nach einem der Ansprüche 1, dadurch gekennzeichnet, daß die Kupferschichten (3, 5, 22) die der Leiterplatte (6, 21) zugewandte Fläche des Bauelements (1) im wesentlichen überdecken und daß die Durchkontaktierungen (4, 23) und die Mittel (7, 24) zur thermisch leitenden Verbindung mit der Haupt-Leiterplatte auf der überdeckten Fläche rasterförmig verteilt sind.

3. Baugruppe nach Anspruch 2, dadurch gekennzeichnet, daß Leiterbahnen (9, 10), weitere Lotkugeln (25) und weitere Durchkontaktierungen an den Rändern der überdeckten Fläche zur Verbindung des Bauelements (1) mit der Haupt-Leiterplatte vorgesehen sind.

4. Baugruppe nach einem der vorhergehenden Ansprüche, dadurch gekennzeichnet, daß das Bauelement mit einer thermisch leitenden Kappe (31, 32) versehen ist, welche thermisch leitend mit der Kupferschicht auf der einen Seite der Leiterplatte verbunden ist.

## Claims

1. Electrical assembly having at least one heat-generating component arranged on one side of a printed circuit board, copper layers (3, 5, 22) being provided in addition to conductor tracks (10) and optionally present plated-through holes, which constitute electrical connections between the sides of the printed circuit board (6), on both sides of the printed circuit board (6) and being interconnected by plated-through holes (4, 23), and the copper layer (3) on one side of the printed circuit board being thermally conductively connected to the component (1), characterized in that the copper layer (5, 22) on the other side of the printed circuit board has, for the purpose of a thermally conductive connection to a main printed circuit board, soldering points produced by the soldering of solder balls (7, 24).

2. Assembly according to Claim 1, characterized in that the copper layers (3, 5, 22) essentially cover that area of the component (1) which faces the printed circuit board (6, 21), and in that the plated-through holes (4, 23) and the means (7, 24) for a thermally conductive connection to the main printed circuit board are distributed in the form of a grid on the covered area.

3. Assembly according to Claim 2, characterized in that conductor tracks (9, 10), further solder balls (25) and further plated-through holes are provided on the edges of the covered area for the purpose of connecting the component (1) to the main printed circuit board.

4. Assembly according to one of the preceding claims, characterized in that the component is provided with a thermally conductive cap (31, 32), which is thermally conductively connected to the copper layer on the one side of the printed circuit board.

## Revendications

1. Eléments constructifs électriques avec au moins un élément constructif qui dégage de la chaleur, élément qui est disposé sur un côté d'une carte à circuit imprimé, dans lequel il est prévu sur les deux côtés de la carte à circuit imprimé (6) des couches de cuivre (3, 5, 22) en plus de pistes conductrices (10) et le cas échéant de trous métallisés existants, qui constituent des liaisons électriques entre les côtés de la carte à circuit imprimé (6), couches de cuivre (3, 5, 22) qui sont reliées entre elles par des trous métallisés (4, 23) et dans lequel la couche de cuivre (3) sur l'un des côtés de la carte à circuit imprimé est en liaison thermiquement conductrice avec l'élément de construction (1),
caractérisés en ce que
la couche de cuivre (5, 22) sur l'autre côté de la carte à circuit imprimé présente des endroits de brasage formés par le brasage de globules de brasage (7, 24) qui servent à établir une liaison thermiquement conductrice avec une carte principale à circuit imprimé.

2. Eléments constructifs selon la revendication 1,
caractérisés en ce que
• les couches de cuivre (3, 5, 22) recouvrent sensiblement la surface de l'élément constructif (1) qui est tournée vers la carte à circuit imprimé (6, 21) et
• les trous métallisés (4, 23) et les moyens (7, 24), qui servent à établir une liaison thermiquement conductrice avec la carte principale à circuit imprimé, sont répartis en forme de grille sur la surface recouverte.

3. Eléments constructifs selon la revendication 2,
caractérisés en ce qu'
on prévoit des pistes conductrices (9, 10), d'autres globules de brasage (25) et d'autres trous métallisés sur les bords de la surface recouverte pour relier l'élément constructif (1) à la carte principale à circuit imprimé.

4. Eléments constructifs selon l'une des revendications précédentes,
caractérisés en ce que
l'élément constructif est pourvu d'un chapeau (31, 32) qui conduit la chaleur et qui est relié de façon thermiquement conductrice à la couche de cuivre sur l'un des côtés de la carte à circuit imprimé.
